Europäisches Patentamt

European Patent Office

Office européen des brevets

(19)

(11) Publication number: **0 407 585 A1**

## EUROPEAN PATENT APPLICATION
## published in accordance with Art. 158(3) EPC

(12)

(21) Application number: 89908259.8

(22) Date of filing: 14.07.89

(86) International application number:
PCT/JP89/00711

(87) International publication number:
WO 90/00814 (25.01.90 90/03)

(51) Int. Cl.5: **H01L 23/29**, H01L 21/56,
H01L 31/02, H01L 31/12,
H01L 33/00

(30) Priority: 15.07.88 JP 1778/88
20.06.89 JP 157329/89

(43) Date of publication of application:
16.01.91 Bulletin 91/03

(84) Designated Contracting States:
DE FR GB

(71) Applicant: TORAY SILICONE CO. LTD.
3-16, Nihombashi-muromachi 2-chome
Chuo-ku Tokyo 103(JP)

(72) Inventor: KOUGO, Akemi
7-8, Todorokicho 1-chome
Chiba-shi Chiba 260(JP)
Inventor: MINE, Katsutoshi
20-2, Aobadai 7-chome
Ichihara-shi Chiba 299-01(JP)

(74) Representative: Laredo, Jack Joseph et al
Elkington and Fife Beacon House 113
Kingsway
London, WC2B 6PP(GB)

(54) SEMICONDUCTOR DEVICE SEALED WITH RESIN AND A METHOD OF PRODUCING THE SAME.

(57) In a semiconductor device sealed with a resin in which a semiconductor chip (1) is connected to externally connecting lead wires (7) via electrically conductive members, and the surface of the semiconductor chip and at least portions of the electrically conductive members close to the semiconductor chip are covered with a cured silicone layer (5a), the improvement wherein the surface of the cured silicone layer is treated with ozone or is irradiated with ultraviolet rays in addition to being treated with ozone, and the surface of said cured silicone layer treated with ozone or irradiated with ultraviolet rays in addition to being treated with ozone, is adhered to the sealing resin (6a) that covers thereon. The invention is further related to a method of producing such devices.

Figure 4

- 2 -

and the inner portions of outward lead wires 7 are sealed and molded with a sealing resin such as an epoxy resin 6a.

In this type of resin-sealed semiconductor device, however, the thickness of the cured silicone layer is generally as relatively large as 100 to 500 m to provide such a state that parts of the gold bonding wires 4a are also embedded in the silicone rubber layer 5a. This presents a problem that the bonding wires 4a may be disconnected in the course of sealing and molding the silicone-covered monolithic IC chip 1, the bonding wires 4a and the inner portions of the outward lead wires 7 with the sealing resin such as the epoxy resin 6a or in the course of a thermal cycle test or a thermal shock test for the thus sealed and molded device.

Further, during the course of surface mounting of the sealed and molded device on a printed circuit board, a heat shock involved not only in dipping the device into a solder bath kept at 260°C but also in subsequently pulling up therefrom and cooling the device may entail problems including disconnection of the gold bonding wires 4a, cracking of the sealing epoxy resin 6a and deterioration of the moisture resistance of the semiconductor device. These problems arise from a failure in integration of the sealing epoxy resin 6a with the silicone rubber layer 5a through adhesion therebetween because the silicone from which the cured silicone layer is formed is not adequately designed. Therefore, rapid expansion or shrinkage of the sealing epoxy resin 6a and the silicone layer 5a, in keeping with a heat shock either in the course of a thermal cycle test or a thermal shock test or in the course of mounting the device on a printed circuit board, causes an interfacial shear, or slippage, therebetween attributed to a difference in the thermal expansion coefficient between the two respective

- 2 -

and the inner portions of outward lead wires 7 are sealed and molded with a sealing resin such as an epoxy resin 6a.

In this type of resin-sealed semiconductor device, however, the thickness of the cured silicone layer is generally as relatively large as 100 to 500 m to provide such a state that parts of the gold bonding wires 4a are also embedded in the silicone rubber layer 5a. This presents a problem that the bonding wires 4a may be disconnected in the course of sealing and molding the silicone-covered monolithic IC chip 1, the bonding wires 4a and the inner portions of the outward lead wires 7 with the sealing resin such as the epoxy resin 6a or in the course of a thermal cycle test or a thermal shock test for the thus sealed and molded device.

Further, during the course of surface mounting of the sealed and molded device on a printed circuit board, a heat shock involved not only in dipping the device into a solder bath kept at 260°C but also in subsequently pulling up therefrom and cooling the device may entail problems including disconnection of the gold bonding wires 4a, cracking of the sealing epoxy resin 6a and deterioration of the moisture resistance of the semiconductor device. These problems arise from a failure in integration of the sealing epoxy resin 6a with the silicone rubber layer 5a through adhesion therebetween because the silicone from which the cured silicone layer is formed is not adequately designed. Therefore, rapid expansion or shrinkage of the sealing epoxy resin 6a and the silicone layer 5a, in keeping with a heat shock either in the course of a thermal cycle test or a thermal shock test or in the course of mounting the device on a printed circuit board, causes an interfacial shear, or slippage, therebetween attributed to a difference in the thermal expansion coefficient between the two respective

at least portions of which in the vicinity of the semiconductor chip(s) as well as the surface(s) of the semiconductor chip(s) are covered with a cured silicone layer with adhesion therebetween, characterized in that the surface of the cured silicone layer is treated with ozone, and in that the ozone-treated surface of the cured silicone layer is integrated with a sealing resin covering the same through adhesion therebetween;

(2) a resin-sealed semiconductor device wherein a semiconductor chip(s) is electrically connected to outward lead wires via electrically conductive members, at least portions of which in the vicinity of the semiconductor chip(s) as well as the surface(s) of the semiconductor chip(s) are covered with a cured silicone layer with adhesion therebetween, characterized in that the surface of the cured silicone layer is treated with ozone and additionally with ultraviolet rays through irradiation of the former with the latter, and in that the ozone- and ultraviolet-treated surface of the cured silicone layer is integrated with a sealing resin covering the same through adhesion therebetween;

(3) a process for producing a resin-sealed semiconductor device of the kind as described in the above item (1), characterized by comprising the step of covering with a curable self-adhesive silicone composition the surface(s) of a semiconductor chip(s) provided in a semiconductor device and electrically connected to outward lead wires via electrically conductive members and at least portions of the electrically conductive members in the vicinity of the semiconductor chip(s), the step of curing the curable self-adhesive silicone composition to form a cured silicone layer adhered to the surface(s) of the semiconductor chip(s) and to at least the portions of the electrically conductive members in the vicinity of the

- 4 -

at least portions of which in the vicinity of the semiconductor chip(s) as well as the surface(s) of the semiconductor chip(s) are covered with a cured silicone layer with adhesion therebetween, characterized in that the surface of the cured silicone layer is treated with ozone, and in that the ozone-treated surface of the cured silicone layer is integrated with a sealing resin covering the same through adhesion therebetween;

(2) a resin-sealed semiconductor device wherein a semiconductor chip(s) is electrically connected to outward lead wires via electrically conductive members, at least portions of which in the vicinity of the semiconductor chip(s) as well as the surface(s) of the semiconductor chip(s) are covered with a cured silicone layer with adhesion therebetween, characterized in that the surface of the cured silicone layer is treated with ozone and additionally with ultraviolet rays through irradiation of the former with the latter, and in that the ozone- and ultraviolet-treated surface of the cured silicone layer is integrated with a sealing resin covering the same through adhesion therebetween;

(3) a process for producing a resin-sealed semiconductor device of the kind as described in the above item (1), characterized by comprising the step of covering with a curable self-adhesive silicone composition the surface(s) of a semiconductor chip(s) provided in a semiconductor device and electrically connected to outward lead wires via electrically conductive members and at least portions of the electrically conductive members in the vicinity of the semiconductor chip(s), the step of curing the curable self-adhesive silicone composition to form a cured silicone layer adhered to the surface(s) of the semiconductor chip(s) and to at least the portions of the electrically conductive members in the vicinity of the

step of curing the curable self-adhesive silicone composition through heating thereof at a comparatively low temperature while treating the same with ozone to form a cured silicone layer adhered to the surface(s) of the semiconductor chip(s) and to at least the portions of the electrically conductive members in the vicinity of the semiconductor chip(s), and the step of sealing and molding the semiconductor device with a sealing resin in such a way as to cover therewith the ozone-treated surface of the cured silicone layer; and
and

(6) a process for producing a resin-sealed semiconductor device of the kind as described in the above item (2), characterized by comprising the step of covering with a curable self-bonding silicone composition the surface(s) of a semiconductor chip(s) provided in a semiconductor device and electrically connected to outward lead wires via electrically conductive members and at least portions of the electrically conductive members in the vicinity of the semiconductor chip(s), the step of curing the curable self-adhesive silicone composition through heating thereof at a comparatively, low temperature while treating the same with ozone and additionally irradiating the same with ultraviolet rays to form a cured silicone layer adhered to the surface(s) of the semiconductor chip(s) and to at least the portions of the electrically conductive members in the vicinity of the semiconductor chip(s), and the step of sealing and molding the semiconductor device with a sealing resin in such a way as to cover therewith the ozone- and ultraviolet-treated surface of the cured silicone layer.

In the following description, the term "semiconductor device" as used in the present invention is intended to cover not only individual semiconductor devices including a diode, a transistor and a thyristor,

step of curing the curable self-adhesive silicone composition through heating thereof at a comparatively low temperature while treating the same with ozone to form a cured silicone layer adhered to the surface(s) of the semiconductor chip(s) and to at least the portions of the electrically conductive members in the vicinity of the semiconductor chip(s), and the step of sealing and molding the semiconductor device with a sealing resin in such a way as to cover therewith the ozone-treated surface of the cured silicone layer; and and

(6) a process for producing a resin-sealed semiconductor device of the kind as described in the above item (2), characterized by comprising the step of covering with a curable self-bonding silicone composition the surface(s) of a semiconductor chip(s) provided in a semiconductor device and electrically connected to outward lead wires via electrically conductive members and at least portions of the electrically conductive members in the vicinity of the semiconductor chip(s), the step of curing the curable self-adhesive silicone composition through heating thereof at a comparatively, low temperature while treating the same with ozone and additionally irradiating the same with ultraviolet rays to form a cured silicone layer adhered to the surface(s) of the semiconductor chip(s) and to at least the portions of the electrically conductive members in the vicinity of the semiconductor chip(s), and the step of sealing and molding the semiconductor device with a sealing resin in such a way as to cover therewith the ozone- and ultraviolet-treated surface of the cured silicone layer.

In the following description, the term. "semiconductor device" as used in the present invention is intended to cover not only individual semiconductor devices including a diode, a transistor and a thyristor,

heating, infrared ray irradiation, and electron beam irradiation. The state of the silicone layer before curing thereof may be liquid, pasty, like a rice cake, powdery, solid, or the like at ordinary temperatures. The cured silicone layer may be like any one of a rigid resin, a rubber, a gel, and substances with a performance between those thereof at ordinary temperature.

The cured silicone layer covers the surface of the semiconductor chip and at least the portions of the electrically conductive members in the vicinity of the semiconductor chip in a state of being adhered to the surface of the semiconductor chip and at least the portions of the electrically conductive members in the vicinity of the semiconductor chip, while at the same time the ozone-treated, or ozone- and ultraviolet-treated surface of the cured silicone layer is integrated with the sealing resin covering the same through adhesion therebetween. The term "integration through adhesion" as used herein refers to such strong adhesion as to lead to a failure in peeling the sealing resin off the cured silicone layer in the interface therebetween even if thermal stress or mechanical stress is applied thereto, and as to result in fracture of either the cured silicone layer or the sealing resin even if forced peeling-off is tried.

Representative examples of the cured silicone forming the cured silicone layer include (1) cured silicones having hydrogen atoms bonded to a silicon atom in a cured state, (2) cured silicones having hydrolyzable groups bonded to a silicon atom in a cured state, (3) cured silicones having alkenyl groups bonded to a silicon atom in a cured state, (4) cured silicones having hydrogen atoms bonded to a silicon atom and hydrolyzable groups bonded to a silicon atom in a cured state, and (5) cured silicones having alkenyl groups bonded to a silicon atom and hydrolyzable groups bonded to a silicon atom.

Examples of the cured silicones (1) include cured products of curable self-adhesive silicone compositions comprising a vinyl-containing organopolysiloxane, an organohydrogen polysiloxane and a platinum compound catalyst blended together as the major materials at such a ratio as to provide a large surplus of hydrogen atoms bonded to a silicon atom as compared with vinyl groups bonded to a silicon atom.

Examples of the cured silicones (2) include cured products of curable self-adhesive silicone compositions comprising a vinyl-containing organopolysiloxane, an organohydrogen polysiloxane, a reactive adhesion promotor (e.g., a vinyltrialkoxysilane, an allyltrialkoxysilane, or a γ-methacryloxypropylalkoxysilane) and a platinum compound catalyst blended together as the major materials.

Examples of the cured silicones (3) include cured products of curable self-adhesive silicone compositions comprising a vinyl-containing organopolysiloxane, an organohydrogen polysiloxane and a platinum compound catalyst blended together as the major materials at such a ratio as to provide a large surplus of vinyl groups bonded to a silicon atom as compared with atoms bonded to a silicon atom.

Examples of the cured silicones (4) include cured products of curable self-adhesive silicone compositions comprising a vinyl-containing organopolysiloxane, an organohydrogen polysiloxane, a reactive adhesion promotor (e.g., a vinyltrialkoxysilane, an allyltrialkoxysilane, or a γ-methacryloxypropylalkoxysilane) and a platinum compound catalyst blended together as the major materials at such a ratio as to provide a large surplus of hydrogen atoms bonded to a silicon atom as compared with vinyl groups bonded to a silicon atom.

Examples of the cured silicones (5) include cured products of curable self-adhesive silicone compositions comprising a vinyl-containing organopolysiloxane, an organohydrogen polysiloxane, a reactive adhesion promotor (e.g., a vinyltrialkoxysilane, an allyltrialkoxysilane, or a γ-methacryloxypropylalkoxysilane) and a platinum compound catalyst blended together as the major materials at such a ratio as to provide a large surplus of vinyl groups bonded to a silicon atoms as compared with hydrogen atoms bonded to a silicon atom. Preferred curable self-adhesive silicone compositions are of the above-mentioned types curable through an addition reaction, among which a thermosetting type is more preferable. However, those of a type curable through a radial reaction with the aid of an organic peroxide or of a type curable through a condensation reaction are also usable.

A curable silicone composition may further comprise an addition reaction retarder, a reinforcing filler, an extender filler, a heat stabilizer, a pigment and/or the like, but the content therein of impurities liable to adversely affect the characteristics of a semiconductor, particularly alkali metals and halogen ions, is desirably at most 1 ppm, while the total content therein of radioactive elements such as uranium and thorium is desirably at most 0.1 ppb from the viewpoint of preventing soft errors attributable to α-rays.

The cured silicone layer covers not only functional parts such as a PN junction area, a MOS gate area, aluminum wirings and bonding pads on the surface of the semiconductor chip, but also the electrically conductive members in the form of bonding wires, solder bumps or beam leads at least in the portions thereof adjacent to the semiconductor chip. If necessary, the cured silicone layer may further cover the side faces of the semiconductor chip and the other portions of the electrically conductive members, while in the case of a hybrid IC it may cover other areas other than the semiconductor chip and the electrically conductive members, examples of which areas include a film circuit, a resistor, and a condenser. In the case of an opto-isolator, the cured silicone layer constitutes a light path between a semiconductor light-emitting element and a semiconductor light-receiving element. Additionally stated, it is preferable that the cured silicone layer should cover the non-functional side face areas of the semiconductor chip as well. The thickness of the cured silicone layer, which may be at least such as to be able to cover therewith the surface of the semiconductor chip and the portions of the electrically conductive members in the vicinity of the semiconductor chip with certainty, is preferably at least a few micrometers, usually about 10 to about 500 μm, and may be up to several millimeters in an extreme case.

The treatment of the surface of the cured silicone layer with ozone or with ozone and ultraviolet rays, which is an important constituent of the present invention, is extremely significant for ensuring such adhesion of the sealing resin to the cured silicone resin as to integrate them together.

The source of ozone to be used in the present invention is not particularly restricted, examples of which include an ozonizer utilizing silent discharge, as used in cleaning photoresists and silicon wafers. The gaseous starting material may either oxygen or air. Although the ozone concentration necessary for effecting the treatment may be varied depending on the properties of the cured silicone layer, the treatment is more effective to enable the treatment time to be shortened, as the concentration is higher. The ozone concentration necessary for the treatment may be 2 to 10 wt. %, while the treatment time may be 1,200 seconds to 1 second, preferably 600 to 30 seconds.

The ultraviolet rays to be used simultaneously with the ozone treatment in the present invention are high-intensity ultraviolet rays, with which the cured silicone layer may be irradiated with either for the same period of time as the ozone treatment time or only for part of the ozone treatment time. Examples of the source of ultraviolet rays include an ultrahigh pressure mercury lamp, a high pressure mercury lamp, a low pressure mercury lamp, and a xenon mercury lamp. Usually, the use of an ultraviolet lamp of 100 to 3,000 W in electric power will suffice. The dose of ultraviolet rays may be varied depending on the properties of the cured silicone and the concentration of ozone used in combination therewith. However, irradiation may usually be done with an ultraviolet lamp of 100 to 3,000 W in electric power for a period of about 300 seconds to about 1 second, preferably for a period of 120 to 10 seconds.

When the cured silicone layer is to be formed from a thermosetting self-adhesive silicone composition in the present invention, the coating film surface of the thermosetting self-adhesive silicone composition covering the surface of the semiconductor chip and at least the portions of the electrically conductive members in the vicinity of the semiconductor chip is treated with ozone or with ozone and ultraviolet rays through irradiation therewith, while at the same time heating the composition. In this case, however, the treatment is preferably effected at a relatively low temperature of at most 200 °C in order to prevent ozone used therefor from being decomposed. The heating may be effected either by a common heating method or with heat generated by a light source lamp used for irradiation with ultraviolet rays.

In the production of the resin-sealed semiconductor device of the present invention, for example, coating of the surface of the semiconductor chip and at least the portions of the electrically conductive members in the vicinity of the semiconductor chip with the above-mentioned curable self-adhesive silicone composition may be followed either by curing of the composition and a subsequent treatment of the surface of the resulting cured silicone layer with ozone alone or with ozone and ultraviolet rays through irradiation therewith, or by curing of the above-mentioned silicone composition in combination with a simultaneous treatment thereof with ozone alone or with ozone and ultraviolet rays through irradiation therewith. In this case, the curable self-adhesive silicone composition is preferably thermosetting, more preferably additionally of a type curable through an addition reaction. The curing is preferably effected through heating. The foregoing treatment may be followed by sealing and molding with a sealing resin such as a sealing epoxy resin in such a way as to encapsulate therein the semiconductor chip, the electrically conductive members and the inner portions of the outward lead wires. Coating methods with the use of a curable self-adhesive silicone composition include dropping, spreading, spraying, and dipping methods. Sealing and molding methods with the use of a sealing resin include transfer molding, injection molding, powder coating, and potting-in-case methods.

The resin-sealed semiconductor device of the present invention is characterized not only by excellent moisture resistance, corrosion resistance and stress relaxation, but also by little liability to undergo disconnection or breakage of the electrically conductive members thereof

EP 0 407 585 A1

- 14 -

such as bonding wires and/or fracture of the sealing resin thereof even when subjected to repeated heat cycles or heat shocks or to repeated turning-on-and-off of electricity, or exposed to heating and pressurizing conditions for a long period of time.

The process of the present invention for producing a resin-sealed semiconductor device is characterized in that resin-sealed semiconductor devices with a cured silicone layer having a surface integrated with a sealing resin covering the layer through adhesion therebetween can be efficiently produced with certainty through a treatment with ozone or with ozone and ultraviolet rays of the surface of a cured silicone layer covering the surface of a semiconductor chip and at least the portions of electrically conductive members in the vicinity of the chip.

Brief Description of the Drawings

Fig. 1 is a cross-sectional view of an adhesion test sample for use in a preliminary test in connection with the present invention;

Fig. 2 is a graph showing the time for development of adhesion in Example 1;

Fig. 3 is a cross-sectional view of a resin-sealed IC of Example 1;

Fig. 4 is a cross-sectional view of a conventional resin-sealed IC;

Fig. 5 is a graph showing the time for development of adhesion in Example 3;

Fig. 6 is a cross-sectional view of an SIP type hybrid IC of Example 3 sealed with a powdery epoxy resin;

Fig. 7 is a cross-sectional view of a conventional SIP type hybrid IC sealed with a powdery epoxy resin;

Fig. 8 is a graph showing the time for development of adhesion in Example 5;

– 15 –

Fig. 9 is a cross-sectional view of a DIP type hybrid IC of Example 5 sealed with a phenolic resin in the form of a solution;

Fig. 10 is a cross-sectional view of a conventional DIP type hybrid IC sealed with a phenolic resin in the form of a solution;

Figs. 11 and 12 are cross-sectional views of reflection type resin-sealed optical coupling semiconductor devices of Examples 7 and 8, respectively, according to the present invention;

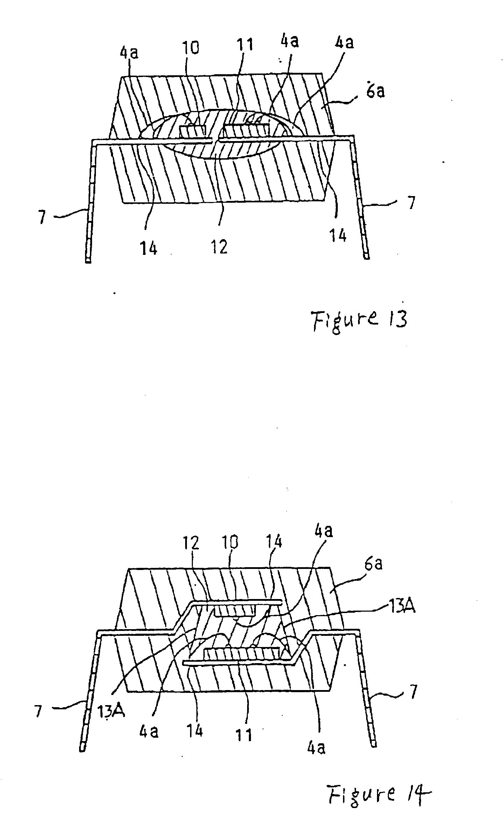

Fig. 13 is a cross-sectional view of a conventional reflection type resin-sealed optical coupling semiconductor device of Comparative Example 4;

Fig. 14 is a cross-sectional view of an opposed type resin-sealed optical coupling semiconductor device of Example 9 according to the present invention; and

Fig. 15 shows the results of dielectric strength tests.

A...cured silicone, B...sealing resin, C...aluminum plate, 1... monolithic IC chips, 2...tabs, 3...bonding pads, 4a...gold bonding wires, 4b...aluminum bonding wires, 5a... silicone rubber layers, 5b...silicone resin layers, 6a...sealing epoxy resin, 6b...sealing phenolic resin, 7...outward lead wires, 8...ceramic substrates, 9...surfaces treated with ozone or with ozone and ultraviolet rays, 10...semiconductor light-emitting elements, 11...semiconductor light-receiving elements, 12...light-transmitting cured silicone rubber, 13A...ozone-treated layers, 13B...ozone- and ultraviolet-treated layers, 14B...inner lead portions provided with semiconductor element.

## Best Modes for Carrying Out the Invention

Examples according to the present invention will now be described together with Comparative Examples

- 16 -

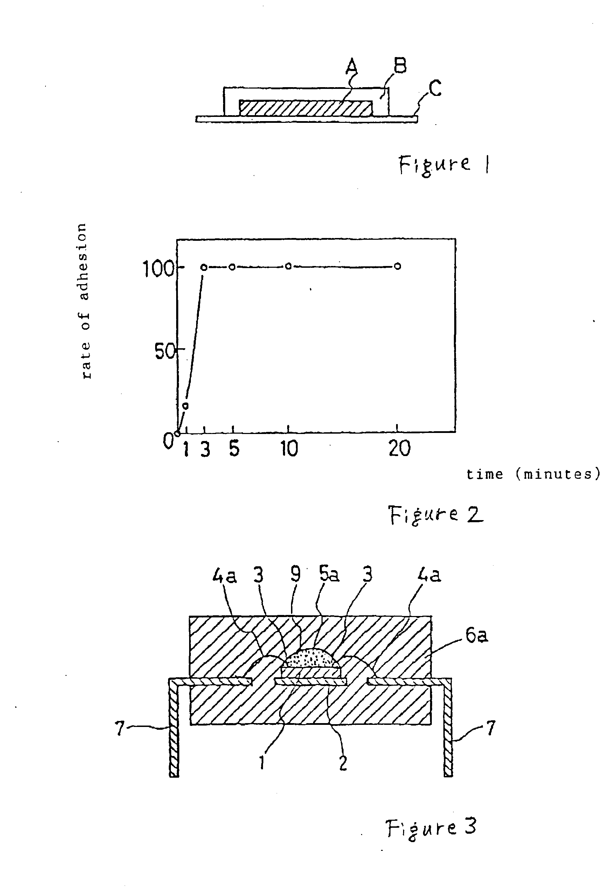

demonstrative of the prior art. Tests for adhesion between a cured silicone and a thermosetting sealing resin covering the same were carried out as preliminary tests in the following manner. Specifically, a curable silicone composition was applied in a 3 cm-square and 1 mm-thick form on an aluminum plate C, and cured by heating to form a cured silicone A, the surface of which was then treated with ozone or with ozone and ultraviolet rays through irradiation therewith. Thereafter, the whole surface of the cured silicone A was sealed and molded with a sealing resin B (see Fig. 1). Subsequently, the sealing resin B was peeled off the cured silicone A in the interface therebetween. The proportion of an area wherein cohesive failure occurred because of adhesion of the cured silicone A to the sealing resin B was referred to as the "rate of adhesion."

"Parts" in Examples and Comparative Examples refer to parts by weight. The viscosities are values found at 25°C.

Heat cycle tests were carried out by continuously repeating a three-hour cycle with the lowest temperature of 180°C. Heat chock tests were carried out by repeating a cycle wherein 30 minutes of temperature keeping at −50 °C was immediately followed by 30 minutes of temperature keeping at 150 °C. Thermal fatigue tests were carried out by repeating turning-on-and-off of electricity.

Initial dielectric strength tests were carried out by applying a voltage of 5.0 KV between an outward lead wire connected to a semiconductor light-emitting element and an outward lead wire connected to a semiconductor light-receiving element. The rate of accepted products was calculated.

Dielectric strength tests were carried out by repeating 10 seconds of voltage application between the two lead wires while changing the voltage in each run from 3.0 KV to 5.0 KV to 8.0 KV to 10.0 KV. The rate of accepted products was calculated.

In a pressure cooker test, a semiconductor device was allowed to stand under conditions (1) involving a temperature of 120 °C, a pressure of 2 atm. and a period of time of 150 hours, or under conditions (2) involving a temperature of 120 °C, a pressure of 2 atm. and a period of time of 300 hours, and then subjected to 10 seconds of application of a voltage of 5 KV between the two lead wires thereof. The rate of accepted products was calculated.

Example 1

Preliminary Teat

A silicone rubber composition of a type curable through an addition reaction, which was composed of:

(a) 100 parts of a methylphenylsiloxane-dimethylsiloxane copolymer having both terminals blocked with a dimethylvinylsiloxy group (molar ratio of the former siloxane units to the latter siloxane units = 1:8, viscosity = 2,000 c.p.).

(b) 3.0 parts of methylhydrogen polysiloxane having both terminals blocked with a trimethylsiloxy group (viscosity = 20 c.p.).

(c) 2.0 parts of allyltrimethoxysilane, and

(d) 5.0 ppm. in terms of the amount of platinum atoms based on the total composition, of a complex of chloroplatinic acid with divinyltetramethyldisiloxane [wherein the molar ratio of hydrogen atoms bonded to a silicon atom to vinyl groups in the component (a) was 2:1], was dropped on aluminum plates for a preliminary test, and kept at 100 °C for 10 minutes to be cured. The resulting cured layers were placed under an atmosphere having an ozone concentration of 5.0 wt. % for respective periods of time of 1, 3, 5, 10 and 20 minutes, and then sealed and molded with a commercially available thermosetting epoxy resin, followed by examination of the respective rates of adhesion. As demonstrated in Fig. 2, samples which showed a rate of adhesion of 100 % were those subjected to at least 3 minutes of the treatment.

Next, the same silicone rubber composition as mentioned above was dropped on the surface of a monolithic IC chip 1 and gold bonding wires 4a in the portions thereof adjacent to the chip 1 which were to be mounted on a wire bonding type resin-sealed IC, kept at 100 °C for 10 minutes to be cured, and placed under an atmosphere having an ozone concentration of 5 wt. % for 3 minutes to effect the treatment thereof, followed by sealing and molding the resulting structure with a commercially available sealing epoxy resin. Thus, a semiconductor device was produced (see Fig. 3).

The cured silicone rubber layer 5a formed from the above-mentioned silicone rubber composition not only covered the surface of a monolithic IC chip 1 and the gold bonding wires 4a around the portions thereof adjacent to the chip 1 in such a way as to be adhering to them, but also was integrated with the sealing epoxy resin 6a covering the ozone-treated surface 9 thereof through strong adhesion therebetween. This resin-sealed IC did not undergo disconnection of the gold bonding wires 4a even when exposed to 2,500 cycles in a heat cycle test. It did not undergo disconnection of the gold bonding wires 4a even when exposed to 800 cycles in a heat shock test as well. The semiconductor device according to the present invention was subjected to 700 hours of PCT (121 °C  2 atm ), and then examined with respect to electrical characteristics. No abnormalities were observed in an aluminum circuit on the surface of the semiconductor chip and the like.

Comparative Example 1

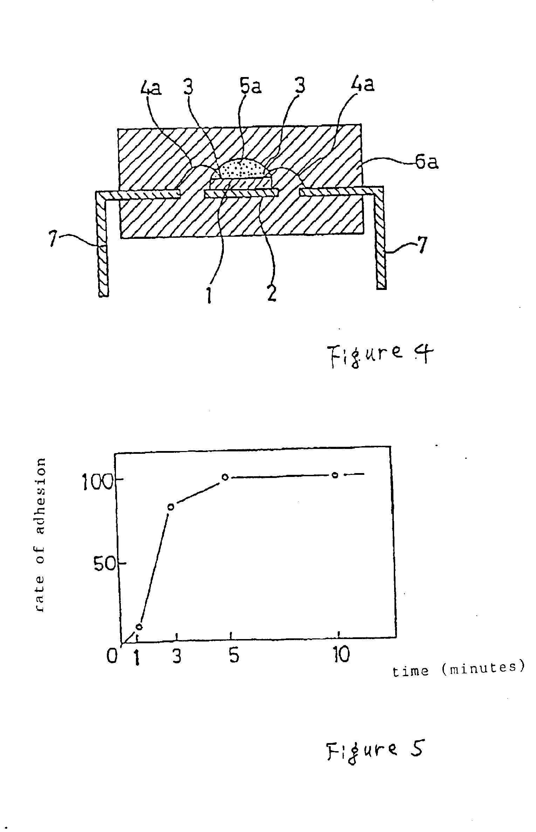

Fig. 4 is a cross-sectional view of an example of conventional wire bonding type resin-sealed IC. A conventional silicone rubber composition of a type curable through an addition reaction, which was composed of 100 parts of the component (a) as used in Example 1, 3.0 parts of the component (b) as used in Example 1 and, 5.0 ppm, in terms of the amount of platinum atoms based on the total composition, of the compound (d) as used in Example 1, was dropped on the surface of a monolithic IC chip 1 and gold bonding wires 4a in the portions thereof adjacent to the chip 1, which were mounted on a tab 2. They were kept at 100 °C for 10 minutes to cure the composition, and then sealed and molded, together with the other portions of the gold bonding wires 4a and the inner portions of outward lead wires 7, with a commercially available sealing epoxy resin 6a.

The cured silicone rubber layer 5a formed from the above-mentioned silicone rubber composition covered the surface of the monolithic IC chip 1 and the gold bonding wires 4a around the portions thereof adjacent to the chip 1 in such a way as to be weakly adhering to them, while seemingly adhering to the sealing epoxy resin 6a covering the same. However, minute gaps between them were observed through a microscope to substantiate no adhesion therebetween.

This resin-sealed IC underwent disconnection of the gold bonding wires 4a when exposed to 200 cycles in a heat cycle test. It underwent disconnection of the gold bonding wires 4a when exposed to 20 cycles in a heat shock test as well.

This device was subjected to 100 hours of PCT (121 °C, 2 atm.) and then examined with respect to electrical characteristics to find occurrence of poor electrical conduction therethrough. A failure analysis was made by removing the sealing epoxy resin 6a and the silicone layer 5a to find partial corrosion of aluminum bonding pads 3 and an aluminum circuit.

Example 2

Preliminary Test

The same silicone rubber composition as used in Example 1 was dropped on an aluminum plate for a preliminary test. The aluminum plate, while placed on a 100 °C hot plate, was placed under an atmosphere having an ozone concentration of 5 wt. % for 60 seconds, and then sealed and molded with a commercially available thermosetting epoxy resin. The rate of adhesion was 100 %.

Next, the above-mentioned silicone rubber composition was dropped on a wire bonding type resin-sealed IC chip. The IC chip, while placed on a 100 °C hot plate, was placed under an atmosphere having an ozone concentration of 5 wt. % for 60 seconds, and then sealed and molded with a commercially available sealing epoxy resin to produce a semiconductor device (not shown in any figures).

The cured silicone rubber layer formed from the above-mentioned silicone rubber composition not only covered the surface of a monolithic IC chip 1 and gold bonding wires around the portions thereof adjacent to the chip in such a way as to be adhering to them, but also was integrated with the sealing epoxy resin covering the ozone-treated surface thereof through strong adhesion therebetween. This resin-sealed IC did not undergo disconnection of the gold bonding wires even when exposed to 2,000 cycles in a heat cycle test. It did not undergo disconnection of the gold bonding wires even when exposed to 600 cycles in a heat shock test as well. The semiconductor device according to the present invention was subjected to 700 hours of PCT (121 °C, 2 atm.), and then examined with respect to electrical characteristics.

No abnormalities were observed in an aluminum circuit on the surface of the semiconductor chip and the like.

Example 3

Preliminary Test

A silicone resin composition of a type curable through an addition reaction, which was composed of:

(a) 100 parts of a silicone resin composed of 8.0 mol % of dimethylvinylsiloxane units, 12 mol % of dimethylsiloxane units and 80 mol % of $SiO_{4/2}$ units,

(b) 6.0 parts of methylhydrogen polysiloxane having both terminals blocked with a trimethylsiloxy group (viscosity = 20 c.p.), and

(c) 5.0 ppm, in terms of the amount of platinum atoms based on the total composition, of a complex of chloroplatinic acid with divinyltetramethyldisiloxane [wherein the molar ratio of hydrogen atoms bonded to a silicon atom to vinyl groups in the component (a) was 5:1],

was applied on aluminum plates for a preliminary test, and kept at 120 °C for 5 minutes to be cured. The resulting cured layers were placed under an atmosphere having an ozone concentration of 3.0 wt. % for respective periods of time of 1, 2, 5 and 10 minutes to effect the treatment thereof, and then sealed and molded with a commercially available powdery epoxy resin, followed by examination of the respective rates of adhesion. As demonstrated in Fig. 5, samples which showed a rate of adhesion of 100 % were those subjected to at least 5 minutes of the treatment.

Next, an SIP type hybrid IC wherein monolithic IC chips 1 were mounted on a ceramic substrate and electrically connected with an outward lead wire 7 via gold bonding wires 4a and aluminum film circuits (not shown in the figure) printed on the substrate 8, was dipped in the same silicone resin composition as mentioned above, taken out, and kept at 120 °C for 5 minutes to cure the composition. Thereafter, it was placed under an atmosphere having an ozone concentration of 3.0 wt. % for 5 minutes, and then sealed and molded with a commercially available powdery epoxy resin to produce a semiconductor device (see Fig. 6).

The cured silicone resin layer 5b formed from the above-mentioned silicone resin composition not only covered with the surfaces and side faces of the monolithic IC chips 1 on the ceramic substrate 8, the gold bonding wires 4a, the other areas of the ceramic substrate 8 and the inner portions of the outward lead wires 7 in such a way as to be adhering to them, but also was integrated with the sealing epoxy resin 6a covering the ozone-treated surface 9 thereof through strong adhesion therebetween. This resin-sealed hybrid IC was subjected to 100 hours of PCT (121 °C, 2 atm.), and then examined with respect to electrical characteristics to find a leakage current of 1 μA, which was the same as the initial value. After 250 hours of PCT (121 °C, 2 atm.), the result was the same. After 350 hours of PCT as well as 100 hours of PCT, aluminum circuits on the surfaces of the monolithic IC chips 1 were found to have undergone neither corrosion nor disconnection.

Comparative Example 2

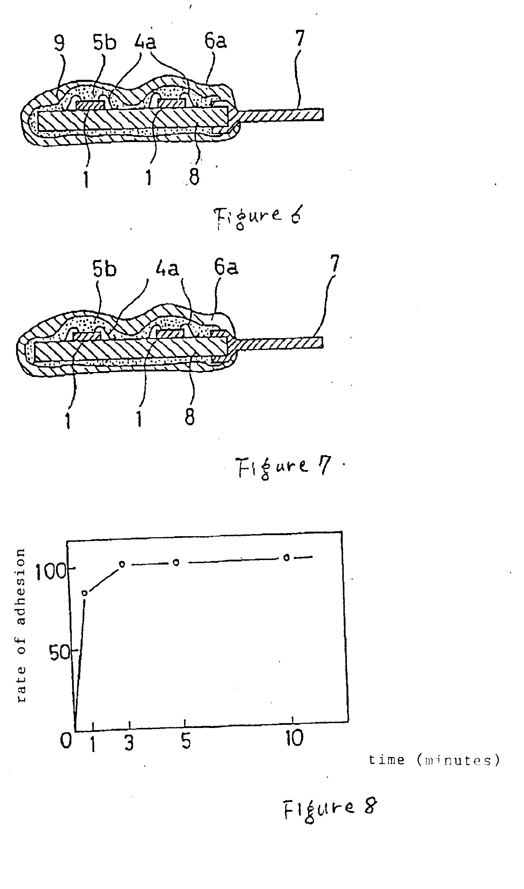

Fig. 7 is a cross-sectional view of an example of conventional SIP type hybrid IC sealed with a powdery epoxy resin.

A hybrid IC wherein monolithic IC chips 1 were mounted on a ceramic substrate 8 and electrically connected with an outward lead wire 7 via gold bonding wires 4a and aluminum film circuits (not shown in the figure) printed on the substrate 8, was dipped in a silicone resin composition of a type curable through an addition reaction, which was composed of 100 parts of the component (a) as used in Example 2, 1.2 parts of the component (b) as used in Example 2, and 5.0 ppm, in terms of the amount of platinum atoms based on the total composition, of the component (c) as used in Example 2 [wherein the molar ratio of hydrogen atoms bonded to a silicon atom to vinyl groups in the component (a) was 1:1]. The IC was taken out, kept at 120 °C for 5 minutes to cure the composition, and sealed and molded with a commercially available powdery epoxy resin.

The cured silicone resin layer 5b formed from the above-mentioned silicone resin composition covered the surface and side faces of the monolithic IC chips 1 on the ceramic substrate 8, the gold bonding wires 4a, the other areas of the ceramic substrate 8 and the inner portion of the outward lead wire 7 in such a way as to be adhering to them, while seemingly adhering to the sealing epoxy resin 6a covering the same. However, minute gaps between them were observed through a microscope to substantiate no adhesion therebetween.

The resin-sealed hybrid IC was subjected to 100 hours of PCT (121 °C, 2 atm.), and then examined with respect to electrical characteristics to find an notable increase in the leakage current therethrough to at least 100 µA. Aluminum circuits on the surface of the monolithic IC chips were found to have undergone partial corrosion and disconnection.

Example 4

The same silicone resin composition as used in Example 3 was applied on aluminum plates for a preliminary test, and kept at 120 °C for 5 minutes to be cured. Thereafter, the resulting cured silicone resin films were placed at a distance of 5 cm from a low pressure mercury lamp of 120 W, irradiated with ultraviolet rays under an atmosphere having an ozone concentration of 3 wt. % for respective periods of time

- 24 -

of 15, 30, 45 and 60 seconds, and sealed and molded with a commercially available powdery epoxy resin, followed by examination of the respective rates of adhesion.

Samples which showed a rate of adhesion of 100 % were those subjected to at least 60 seconds of the treatment (not shown in any figures).

Next, an SIP type hybrid IC was dipped in the same silicone resin composition as mentioned above in the same manner as in Example 3, taken out, and kept at 120 °C for 5 minutes to form a cured layer, which was then simultaneously treated with ozone and ultraviolet rays, followed by sealing and molding the resulting structure with a commercially available powdery epoxy resin. Thus, a semiconductor device was produced (not shown in any figurers).

The cured silicone resin layer formed from the above-mentioned silicone resin composition not only covered the surfaces and side faces of monolithic IC chips on a ceramic substrate, gold bonding wires, the other areas of the ceramic substrate and the inner portions of an outward lead wire 7 in such a way as to be adhering to them, but also was integrated with the sealing epoxy resin covering the ozone- and ultraviolet-treated surface thereof through strong adhesion therebetween.

This resin-sealed hybrid IC was subjected to 100 hours of PCT (121 °C, 2 atm.). Thereafter, the leakage current therethrough was measured to be still 1 µA, which was the same as the initial value. After 250 hours of PCT (121 °C, 2 atm.), the result was the same. After 350 hours of PCT, aluminum circuits on the surface of the monolithic IC chips were found to have undergone neither corrosion nor disconnection.

Example 5

Preliminary Test

- 25 -

A silicone rubber composition of a type curable through an addition reaction, which was composed of:

(a) 100 parts of dimethylpolysiloxane having both terminals blocked with a dimethylvinylsiloxy group (viscosity = 4,000 c.p.),

(b) 0.5 part of methylhydrogen polysiloxane having both terminals blocked with a trimethylsiloxy group (viscosity = 20 c.p.),

(c) 5.0 ppm, in terms of the amount of platinum atoms based on the total composition, of a complex of chloroplatinic acid with divinyltetramethyldisiloxane, and

(d) 2.0 parts of γ-methacryloxypropyltrimethoxy-silane

[wherein the molar ratio of hydrogen atoms bonded to a silicon atom to vinyl groups in the component (a) was 4:1],

was dropped on aluminum plates for a preliminary test, and kept at 150 °C for 1 minute to be cured. They were placed under an atmosphere having an ozone concentration of 6.0 wt. % for respective periods of time of 1, 3, 5 and 10 minutes, and then sealed and molded with a commercially available liquid phenolic resin. As demonstrated in Fig. 8, samples which showed a rate of adhesion of 100 % were those subjected to at least 3 minutes of the treatment.

Next, the same silicone rubber composition as mentioned above was dropped on monolithic IC chips 1 and aluminum bonding wires 4b in a hybrid IC wherein the monolithic IC chips 1 were mounted on the two surfaces of a ceramic substrate 8 and electrically connected with outward lead wires 7 via the aluminum bonding wires 4b and aluminum film circuits (not shown in the figure) printed on the substrate. Thereafter, the resulting structure was kept at 150 °C for 1 minute to cure the composition, and placed under an atmosphere having an ozone concentration of 6 wt. % for 3 minutes to effect a treatment. Subsequently, the whole structure including the substrate and the cured silicone was sealed and molded with a commercially available sealing phenolic resin in the form of a solution to produce a DIP type hybrid IC of a double-side mounting type (see Fig. 8).

The cured silicone rubber layer 5a formed from the above-mentioned silicone rubber composition not only covered the surfaces of the monolithic IC chips 1 on the ceramic substrate 8, the aluminum bonding wires 4b, parts of the outward lead wires 7 and the two surfaces of the ceramic substrate 8 in the peripheral areas thereof around the IC chips 1 in such a way as to be adhering to them, but also was integrated with the sealing phenolic resin 6b covering the ozone-treated surface 9 thereof through strong adhesion therebetween.

This resin-sealed hybrid IC was subjected to 300 hours of PCT (121 °C, 2 atm.), and then examined with respect to electrical characteristics to find a leakage current therethrough of 1 μA, which was the same as the initial value. Aluminum circuits on the monolithic IC chips 1 and the aluminum bonding wires 4b were found to have undergone neither corrosion nor disconnection.

Comparative Example 3

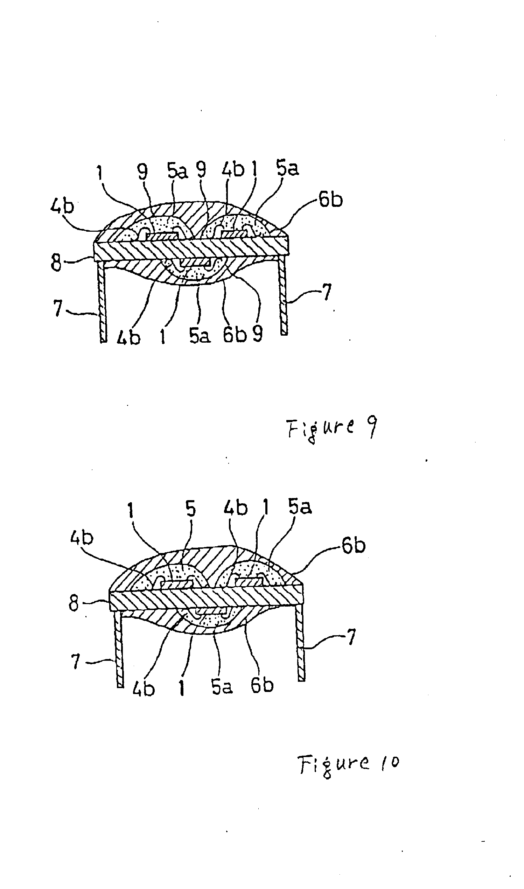

Fig. 10 is a cross-sectional view of a conventional DIP type hybrid IC sealed with a phenolic resin in the form of a solution. In the hybrid IC wherein monolithic IC chips 1 were mounted on the two surfaces of a ceramic substrate 8 and electrically connected with outward lead wires 7 via aluminum bonding wires 4b and aluminum film circuits (not shown in the figure) printed on the ceramic substrate 8, a silicone rubber composition of a type curable through an addition reaction, which was composed of 100 parts of the component (a) as used in Example 5, 0.125 part of the component (b) as used in Example 5, and 5.0 ppm, in terms of the amount of platinum atoms based on the total composition, of the component (c) as used in Example 5 [wherein the molar ratio of hydrogen atoms bonded to a silicon atom to vinyl groups in the component (a) was 1:1], was dropped on the IC chips 1 and the aluminum bonding wires 4b, kept at 150 °C for 1 minute to be cured, and then sealed and molded, together with parts of the outward lead wires 7, with a commercially available sealing phenolic resin in the form of a solution.

The cured silicone rubber layer 5a formed from the above-mentioned silicone rubber composition covered with the surface of the monolithic IC chips 1 on the ceramic substrate 8, the aluminum bonding wires 4b and the two surfaces of the ceramic substrate 8 in the peripheral areas thereof around the IC chips 1 in such a way as to be weakly adhering to them, while seemingly adhering to the sealing phenolic resin 6b covering the same. However, minute gaps between them were observed through a microscope to substantiate no adhesion therebetween.

This resin-sealed hybrid IC was subjected to 150 hours of PCT (121 °C, 2 atm.), and then examined with respect to electrical characteristics to find a notable increase in the leakage current therethrough to at least 100 µA. Aluminum circuits on the monolithic IC chips 1 and the aluminum bonding wires 4b were found to have undergone partial corrosion and disconnection.

Example 6

Preliminary Test

The same silicone rubber composition as used in Example 5 was dropped on aluminum plates for a preliminary test, and kept at 150 °C for 1 minute to be cured. The resulting cured silicone layers were placed at a distance of 5 cm from a 1,500 W ultrahigh pressure mercury lamp, irradiated with ultraviolet rays under an atmosphere having an ozone concentration of 6 wt. % for respective periods of time of 15 seconds, 30 seconds, 60 seconds and 90 seconds, and then sealed and molded with a commercially available sealing phenolic resin in the form of a solution. Samples which showed a rate of adhesion of 100 % between the sealing resin and the cured silicone layer were those subjected to at least 30 seconds of the irradiation with ultraviolet rays.

Next, the above-mentioned silicone rubber composition was dropped on a DIP type hybrid IC chip in the same manner as in Example 5, and kept at 150 °C for 1 minute to be cured. The resulting cured layer was simultaneously treated with ozone and ultraviolet rays under the same conditions as in the above-mentioned preliminary test for 30 seconds, and then sealed and molded with a commercially available sealing phenolic resin in the form of a solution to produce a semiconductor device (not shown in any figures).

The cured silicone rubber layer formed from the above-mentioned silicone rubber composition not only covered the surfaces and side faces of monolithic IC chips on a ceramic substrate, aluminum bonding wires, the other areas of the ceramic substrate and parts of outward lead wires in such a way as to be adhering to them, but also was integrated with the sealing phenolic resin covering the ozone- and ultraviolet-treated surface thereof through strong adhesion therebetween. This resin-sealed hybrid IC was subjected to 300 hours of PCT (121 °C, 2 atm.), and then examined with respect to electrical characteristics to find a leakage current therethrough of 1 µA, which was the same as the initial value. Aluminum circuits on the monolithic IC chips and the aluminum bonding wires were found to have undergone neither corrosion nor disconnection.

Example 7

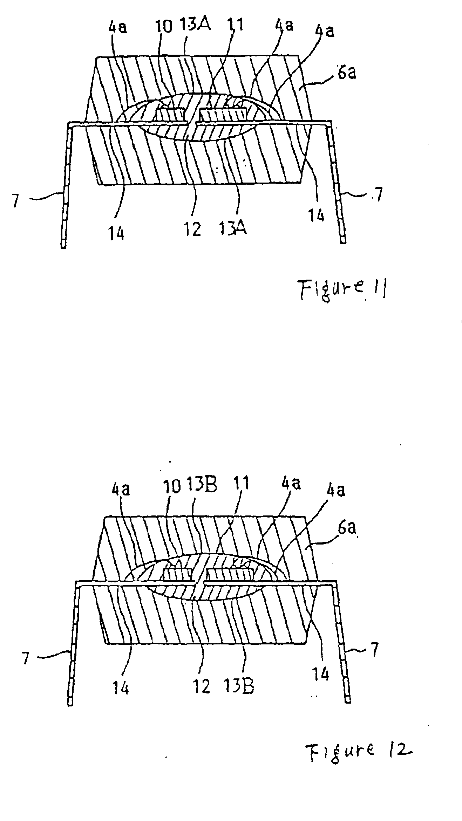

Fig. 11 is a cross-sectional view of a reflection type resin-sealed optical coupling semiconductor device according to an embodiment of the present invention. This semiconductor device was produced in the following manner. A self-adhesive silicone rubber composition of a type curable through an addition reaction, which was composed of:

(a) 100 parts of a methylphenylsiloxane-dimethylsiloxane copolymer having both terminals blocked with a dimethylvinylsiloxy group (molar ratio of methylphenylsiloxane units to dimethylsiloxane units = 1:9, viscosity = 5,000 c.p.).

(b) 3.0 parts of methylhydrogen polysiloxane having both terminals blocked with a trimethylsiloxy group (viscosity = 20 c.p.),

(c) 2.0 parts of allyltrimethoxysilane, and

(d) 5.0 ppm, in terms of the amount of platinum atoms based on the total composition, of a complex of chloroplatinic acid with divinyltetramethyldisiloxane [wherein the molar ratio of hydrogen atoms bonded to a silicon atom to vinyl groups in the component (a) was 2:1],

was dropped on a semiconductor light-emitting element 10, a gold bonding wire 4a in the portion thereof adjacent to the semiconductor light-emitting element 10, an inner lead portion 14 in the part thereof adjacent to the semiconductor light-emitting element 10, a semiconductor light-receiving element 11, gold bonding wires in the portions thereof adjacent to the semiconductor light-receiving element 11, and another inner lead portion 14 in the part thereof adjacent to the semiconductor light-receiving element 11. The resulting structure was kept at 120 °C for 10 minutes to cure the composition. The resulting light-transmitting cured silicone rubber 12 was

— 30 —

placed under an atmosphere having an ozone concentration of 5.0 wt. % for 10 minutes to effect the treatment thereof to thereby form an ozone-treated layer 13A in the surface portion of the cured silicone rubber 12, and then sealed and molded with a commercially available sealing epoxy resin 6a, with which the other portions of the gold bonding wires 4a, the other parts of the inner lead portions 14 and another inner lead portion (not shown in the figure) connected with the gold bonding wire 4a were sealed and molded as well.

In the case of resin-sealed optical coupling semiconductor devices of the type as described above, the rate of accepted products was 100 % in an initial dielectric strength test, while the rate of accepted products was 95 % in a dielectric strength test even with an applied voltage of 7 KV (see Fig. 15).

A failure analysis was made to find out that electrical rupture occurred inside the cured silicone rubber 12.

In a pressure cooker test, results as shown in Table 1 were obtained.

Additionally stated, the dielectric breakdown strength of the cured silicone rubber itself was 15 KV/mm.

Comparative Example 4

Fig. 3 is a cross-sectional view of a conventional reflection type resin-sealed optical coupling semiconductor device. This semiconductor device was produced in the following manner. The same silicone rubber composition of a type curable through an addition reaction as used in Example 7 was dropped on a semiconductor light-emitting element 10, a semiconductor light-receiving element 11 and gold bonding wires 4a in the portions thereof adjacent to the two elements. The resulting structure was kept at 120 °C for 10 minutes to

- 31 -

cure the composition. The resulting light-transmitting cured silicone rubber 12 was sealed and molded with a commercially available sealing epoxy resin 6a, with which the other portions of the gold bonding wires 4a, the other parts of the inner lead portions 14 and another inner lead portion (not shown in the figure) connected with the gold bonding wire 4a were sealed and molded as well.

The light-transmitting cured silicone rubber 12 covered the semiconductor light-emitting element 10, the semiconductor light-receiving element 11, the gold bonding wires 4a around the portions thereof adjacent to the two elements and the inner lead portions 14 around the parts thereof adjacent to the two elements in such a way as to be weakly adhering to them, while seemingly adhering to the sealing epoxy resin 6a covering the same. However, minute gaps between them were observed through a microscope to substantiate no adhesion therebetween.

In the case of resin-sealed optical coupling semiconductor devices of the type as described above, the rate of accepted products was 80 % in an initial dielectric strength test, while the rate of accepted products was 60 % in a dielectric strength test with an applied voltage of 7 KV and 5 % in a dielectric strength test with an applied voltage of 10 KV (see Fig. 15).

A failure analysis was made to find out that electrical rupture occurred in the interface between the cured silicone rubber 12 and the sealing epoxy resin 6a.

In a pressure cooker test, results as shown in Table 1 were obtained.

Example 8

The same silicone rubber composition of a type curable through an addition reaction as used in Example 7 was cured under the same curing conditions as in Example 7. The resulting light-transmitting cured silicone rubber was placed at a distance of 5 cm from a 1,500 W ultrahigh pressure mercury lamp, irradiated with ultraviolet rays under an atmosphere having an ozone concentration of 6 wt. % for 90 seconds to effect the treatment thereof, and then sealed and molded with a commercially available sealing epoxy resin to produce a reflection type resin-sealed optical coupling semiconductor device.

As shown in Fig. 12, the light-transmitting cured silicone rubber 12 not only covered a semiconductor light-emitting element 10, a semiconductor light-receiving element 11, gold bonding wires 4a around the portions thereof adjacent to the two elements and inner lead portions 14 around the parts thereof adjacent to the two elements in such as way as to be strongly adhering to them, but also was integrated with the sealing epoxy resin 6a covering the ozone- and ultraviolet-treated surface 13B thereof through strong adhesion therebetween.

In the case of resin-sealed optical coupling semiconductor devices of the type as described above, the rate of accepted products was 100 % in an initial dielectric strength test, while the rate of accepted products was 95 % in a dielectric strength test even with an applied voltage of 10 KV.

A failure analysis was made to find out that electrical rupture occurred inside the cured silicone rubber 12.

In a pressure cooker test, results as shown in Table 1 were obtained.

Example 9

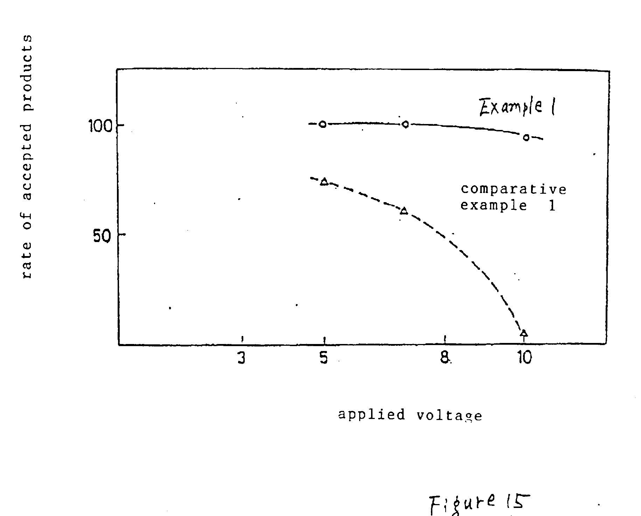

Fig. 14 is a cross-sectional view of an opposed type resin-sealed optical coupling semiconductor device according to an embodiment of the present invention.

This semiconductor device was produced in the following manner. A self-adhesive silicone rubber composition of a type curable through an addition reaction, which was composed of:

(a) 100 parts of a methylphenylsiloxane-dimethylsiloxane copolymer having both terminals blocked with a dimethylvinylsiloxy group (molar ratio of methylphenylsiloxane units to dimethylsiloxane units = 1:9, viscosity = 5,000 c.p.).

(b) 1.0 part of methylhydrogen polysiloxane having both terminals blocked with a trimethylsiloxy group (viscosity = 20 c.p.),

(c) 2.0 parts of γ-methacryloxypropyltrimethoxy-silane, and

(d) 5.0 ppm, in terms of the amount of platinum atoms based on the total composition, of a complex of chloroplatinic acid with divinyltetramethyldisiloxane [wherein the molar ratio of hydrogen atoms bonded to a silicon atom to vinyl groups in the component (a) was 3:1],

was dropped on a semiconductor light-emitting element 10, a gold bonding wire 4a in the portion thereof adjacent to the semiconductor light-emitting element 10, an inner lead portion 14 with the semiconductor light-emitting element 10 mounted thereon in the part thereof adjacent to the semiconductor light-emitting element 10, a semiconductor light-receiving element 11, gold bonding wires 4a in the portions thereof adjacent to the semiconductor light-receiving element 11, and another inner lead portion 14 with the semiconductor light-receiving element 11 mounted thereon in the part thereof adjacent to the semiconductor light-receiving element 11. The resulting structure was kept at 100 °C for 20 minutes to cure the composition. The resulting light-transmitting cured silicone rubber 12 was placed under an atmosphere having an ozone concentration of 6.0 wt. % for 15 minutes to form an ozone-treated layer 13A in the surface portion

- 34 -

of the cured silicone rubber 12, and then sealed and molded with a commercially available sealing epoxy resin 6a, with which the other parts of the inner lead portions 14 and another inner lead portion (not shown in the figure) connected with the gold bonding wire 4a were sealed and molded as well.

The cured silicone rubber 12 not only covered the semiconductor light-emitting element 10, the semiconductor light-receiving element 11, the bonding wires 4a around the portions thereof adjacent to the two elements and the inner lead portions 14 around the parts thereof adjacent to the two elements in such as way as to be strongly adhering to them, but also was integrated with the sealing epoxy resin 7 covering the ozone-treated surface 13A thereof through strong adhesion therebetween.

In the case of resin-sealed optical coupling semiconductor devices of the type as described above, the rate of accepted products was 100 % in an initial dielectric strength test, while the rate of accepted products was 95 % in a dielectric strength test even with an applied voltage of 10 KV.

A failure analysis was made to find out that electrical rupture occurred inside the cured silicone rubber 5.

In a pressure cooker test, results as shown in Table 1 were obtained.

Additionally stated, the dielectric breakdown strength of the cured silicone rubber itself was 13.2 KV/mm.

- 35 -

Table 1: Results of Pressure Cooker Tests

| Runs / Test Conditions | Ex. 7 | Comp. Ex. 4 | Ex. 8 | Ex. 9 |
|---|---|---|---|---|
| (1) | 100 | 73 | 100 | 100 |
| (2) | 100 | 57 | 100 | 98 |

- 36 -

## Fields of Industrial Application

The resin-sealed semiconductor device of the present invention is very useful in a computer, a television set, a video, a tape recorder, machines with an automatic control system, etc.

CLAIMS

1. A resin-sealed semiconductor device wherein a semiconductor chip(s) is electrically connected to outward lead wires via electrically conductive members, at least portions of which in the vicinity of said semiconductor chip(s) as well as the surface(s) of said semiconductor chip(s) are covered with a cured silicone layer with adhesion therebetween, characterized in that the surface of said cured silicone layer is treated with ozone, and in that the ozone-treated surface of said cured silicone layer is integrated with a sealing resin covering the same through adhesion therebetween.

2. A resin-sealed semiconductor device as claimed in claim 1, wherein said ozone-treated surface of said cured silicone layer is further treated with ultraviolet rays through irradiation of the former with the latter, and wherein the ozone- and ultraviolet-treated surface of said cured silicone layer is integrated with said sealing resin covering the same through adhesion therebetween.

3. A resin-sealed semiconductor device as claimed in claim 1 or 2, wherein said cured silicone layer is formed by curing a self-adhesive thermosetting silicone composition.

4. A resin-sealed semiconductor device as claimed in claim 3, wherein said self-adhesive thermosetting silicone composition is of a type curable through an addition reaction.

5. A resin-sealed semiconductor device as claimed in claim 1 or 2, characterized in that a semiconductor light-emitting element and a semiconductor light-receiving element are used in combination as said semiconductor chips, and optically coupled with each other by means of said cured silicone layer provided therebetween, which is light-transmitting.

6. A process for producing a resin-sealed semiconductor device as claimed in claim 1, characterized by comprising the step of covering with a curable self-adhesive silicone composition the surface(s) of a semiconductor chip(s) provided in a semiconductor device and electrically connected to outward lead wires via electrically conductive members and at least portions of said electrically conductive members in the vicinity of said semiconductor chip(s), the step of curing said curable self-adhesive silicone composition to form a cured silicone layer adhered to said surface(s) of said semiconductor chip(s) and to said at least portions of said electrically conductive members in the vicinity of said semiconductor chip(s), the step of treating said cured silicone layer with ozone, and the step of sealing and molding said semiconductor device with a sealing resin in such a way as to cover therewith the ozone-treated surface of said cured silicone layer.

7. A process for producing a resin-sealed semiconductor device as claimed in claim 2, characterized by comprising the step of covering with a curable self-adhesive silicone composition the surface(s) of a semiconductor chip(s) provided in a semiconductor device and electrically connected to outward lead wires via electrically conductive members and at least portions said electrically conductive members in the vicinity said semiconductor chip(s), the step of curing said curable self-adhesive silicone composition to form a cured silicone layer adhered to said surface(s) of said semiconductor chip(s) and to said at least portions of said electrically conductive members in the vicinity of said semiconductor chip(s), the step of treating said cured silicone layer with ozone and additionally irradiating said cured silicone layer with ultraviolet rays, and the step of sealing and molding said semiconductor device with a sealing resin in such a way as to cover therewith the ozone- and ultraviolet-treated surface of said cured silicone layer.

8. A process for producing a resin-sealed semiconductor device as claimed in claim 1, characterized by comprising the step of covering with a curable self-bonding silicone composition the surface(s) of a semiconductor chip(s) provided in a semiconductor device and electrically connected to outward lead wires via electrically conductive members and at least portions of said electrically conductive members in the vicinity of said semiconductor chip(s), the step of curing said curable self-adhesive silicone composition through heating thereof at a comparatively low temperature while treating the same with ozone to form a cured silicone layer adhered to said surface(s) of said semiconductor chip(s) and to said at least portions of said electrically conductive members in the vicinity of said semiconductor chip(s), and the step of sealing and molding said semiconductor device with a sealing resin in such a way as to cover therewith the ozone-treated surface of said cured silicone layer.

9. A process for producing a resin-sealed semiconductor device as claimed in claim 2, characterized by comprising the step of covering with a curable self-bonding silicone composition the surface(s) of a semiconductor chip(s) provided in a semiconductor device and electrically connected to outward lead wires via electrically conductive members and at least portions of said electrically conductive members in the vicinity of said semiconductor chip(s), the step of curing said curable self-adhesive silicone composition through heating thereof at a comparatively low temperature while treating the same with ozone and additionally irradiating the same with ultraviolet rays to form a cured silicone layer adhered to said surface(s) of said semiconductor chip(s) and to said at least portions of said electrically conductive members in the vicinity of said semiconductor chip(s), and the step of sealing and molding said semiconductor device with a sealing resin in such a way as to cover therewith the ozone- and ultraviolet-treated surface of said cured silicone layer.

10. A process for producing a resin-sealed semiconductor device as claimed in claim 6, 7, 8 or 9, characterized in that a semiconductor light-emitting element and a semiconductor light-receiving element are used in combination as said semiconductor chips and are optically coupled with each other by means of said cured silicone layer provided therebetween, and in that said curable self-adhesive silicone composition and said cured silicone layer are light-transmitting.

Figure 1

rate of adhesion

time (minutes)

Figure 2

Figure 3

Figure 4

Figure 5

Figure 6

Figure 7

Figure 8

Figure 9

Figure 10

Figure 11

Figure 12

Figure 13

Figure 14

Figure 15

# INTERNATIONAL SEARCH REPORT

International Application No  PCT/JP89/00711

## I. CLASSIFICATION OF SUBJECT MATTER (if several classification symbols apply, indicate all) 6

According to International Patent Classification (IPC) or to both National Classification and IPC

Int. Cl$^4$    H01L23/30, 21/56, 31/02, 31/12, 33/00

## II. FIELDS SEARCHED

| Minimum Documentation Searched 7 | |
|---|---|
| Classification System | Classification Symbols |
| IPC | H01L23/30, 21/56, 31/02, 31/12, 33/00, 23/28 |

Documentation Searched other than Minimum Documentation
to the Extent that such Documents are Included in the Fields Searched 8

| | |
|---|---|
| Jitsuyo Shinan Koho | 1926 – 1988 |
| Kokai Jitsuyo Shinan Koho | 1971 – 1988 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | JP, A, 51-3578 (NEC Corporation) 13 January 1976 (13. 01. 76) | 1 – 10 |
| A | JP, A, 63-21860 (Oki Electric Industry Co., Ltd.) 29 January 1988 (29. 01. 88) | 1 – 10 |
| A | JP, A, 62-133741 (NEC Corporation) 16 June 1987 (16. 06. 87) | 1 – 10 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 2, 1989 (02. 10. 89) | October 16, 1989 (16. 10. 89) |
| International Searching Authority | Signature of Authorized Officer |
| Japanese Patent Office | |

Form PCT/ISA/210 (second sheet) (January 1985)